(19) Europäisches Patentamt
European Patent Office
Office européen des brevets

(11) **EP 4 722 426 A1**

(12) **EUROPEAN PATENT APPLICATION**
published in accordance with Art. 153(4) EPC

(43) Date of publication:
08.04.2026 Bulletin 2026/15

(21) Application number: 24893621.3

(22) Date of filing: 22.11.2024

(51) International Patent Classification (IPC):
*C30B 29/10* (2006.01)    *H01M 4/505* (2010.01)
*H01M 4/525* (2010.01)

(52) Cooperative Patent Classification (CPC):
Y02E 60/10

(86) International application number:
**PCT/CN2024/134001**

(87) International publication number:
**WO 2025/108468 (30.05.2025 Gazette 2025/22)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: 24.11.2023 CN 202311586595

(71) Applicant: Ningbo Ronbay New Energy
Technology Co., Ltd.
Yuyao Ningbo, Zhejiang 315402 (CN)

(72) Inventors:
• HUANG, Xiaoxiao
Ningbo, Zhejiang 315402 (CN)
• GUO, Xiaohua
Ningbo, Zhejiang 315402 (CN)
• YU, Jian
Ningbo, Zhejiang 315402 (CN)
• YUAN, Xujun
Ningbo, Zhejiang 315402 (CN)

(74) Representative: J A Kemp LLP
80 Turnmill Street
London EC1M 5QU (GB)

(54) **SINGLE CRYSTAL TERNARY POSITIVE ELECTRODE MATERIAL AND PREPARATION METHOD THEREFOR AND USE THEREOF**

(57) The present application provides a single-crystal ternary positive electrode material and a preparation method and an application thereof. The single-crystal ternary positive electrode material satisfies the following relationships: $1\,\mu m \leq P < 5\,\mu m$, $1 \leq D_2/D_1 < 10$, and $3\,\mu m < D50 < 8\,\mu m$, where P is a single-crystal size of the single-crystal ternary positive electrode material, $D_1$ is a mass proportion of the single-crystal ternary positive electrode material with a single-crystal size $< 2.5\,\mu m$, $D_2$ is a mass proportion of the single-crystal ternary positive electrode material with a single-crystal size $\geq 2.5\,\mu m$, and D50 is a median particle size of the single-crystal ternary positive electrode material. The single-crystal ternary positive electrode material provided by the present application includes two single-crystal materials with different sizes, and with the limitation on the particle size and proportion of the single-crystal materials with different sizes, the single-crystal ternary positive electrode material has relatively high compaction density and excellent cycling performance.

FIG. 1

EP 4 722 426 A1

**Description**

The present application claims priority to the Chinese Patent Application No. 202311586595.9, filed with China National Intellectual Property Administration on November 24, 2023, entitled "single-crystal ternary positive electrode material and preparation method and application thereof". The aforementioned patent application is hereby incorporated by reference in its entirety.

**TECHNICAL FIELD**

The present application relates to the technical field of battery materials, and in particular, to a single-crystal ternary positive electrode material and a preparation method and an application thereof.

**BACKGROUND**

Single-crystal ternary materials exhibit superior cycling stability compared to polycrystalline ternary materials. However, the single-crystal ternary materials have a relatively low lithium-ion diffusion rate, resulting in poor rate performance. To enhance the rate performance of the single-crystal ternary materials, a conventional approach involves reducing particle sizes of the single-crystal ternary materials (typically < 2 μm). However, small-sized single-crystal ternary materials have a relatively low compaction density. To address the above problems, existing technologies involve blending the small-sized single-crystal ternary materials with large-sized polycrystalline ternary materials to enhance the compaction density of the single-crystal ternary materials. However, this approach typically comes at an expense of some cycling performance, thereby limiting application scenarios of the positive electrode materials.

**SUMMARY**

In view of this, the present application provides a single-crystal ternary positive electrode material. This positive electrode material includes two single-crystal materials with different sizes, and with the limitation on the proportion of the single-crystal materials with different sizes, the positive electrode material achieves a high compaction density and excellent cycling performance.

The present application further provides a preparation method for a single-crystal ternary positive electrode material. The aforementioned single-crystal ternary positive electrode material can be prepared using the preparation method with a simple process.

The present application further provides a positive electrode sheet including the aforementioned single-crystal ternary positive electrode material, and thus when the positive electrode sheet is used in a battery, the electrical performance and cycling performance of the battery can be improved.

The present application further provides a battery including the aforementioned positive electrode sheet, and thus the battery exhibits excellent electrical performance and cycling stability.

In a first aspect, the present application provides a single-crystal ternary positive electrode material, satisfying the following equations 1 to 3:

$$1 \ \mu m \leq P < 5 \ \mu m \qquad\qquad \text{equation 1,}$$

$$1 \leq D_2/D_1 < 10 \qquad\qquad \text{equation 2,}$$

$$3 \ \mu m < D50 < 8 \ \mu m \qquad\qquad \text{equation 3;}$$

where P is a single-crystal size of the single-crystal ternary positive electrode material, $D_1$ is a mass proportion of the single-crystal ternary positive electrode material with a single-crystal size < 2.5 μm, $D_2$ is a mass proportion of the single-crystal ternary positive electrode material with a single-crystal size ≥ 2.5 μm, and D50 is a median particle size of the single-crystal ternary positive electrode material.

Preferably, the following equation 4 is further satisfied:

$$1 < N_2/N_1 < 1.2 \qquad\qquad \text{equation 4,}$$

where $N_1$ is a Ni content of the single-crystal ternary positive electrode material with a single-crystal size ≥ 2.5 μm, and $N_2$ is a Ni content of the single-crystal ternary positive electrode material with a single-crystal size < 2.5 μm.

Preferably, the single-crystal ternary positive electrode material includes a core and a coating layer coated on at least part of a surface of the core; the core has a molecular formula of $Li_{1+a}[Ni_xCo_yMn_zM_bN_c]O_2$, where $0 < a < 0.1$, $0 < b < 0.2$, $0 < c < 0.2$, $0.5 \leq x < 1$, $0 < y < 0.3$, $0 < z < 0.3$, $x + y + z + b + c = 1$, M is selected from one or more of Zr, Mg, Ti, Al, La, Ca, Sr, Sb, Nb, Pb, V, Ge, W, Mo, Zn, Ce and Y, and N is selected from one or more of B, P, S, Si, Se and Te; the coating layer includes a metallic lithium compound containing one or more of elements Co, Ti, La, Al, Nb, W, Zr, Y, and Ta, and/or a non-metallic lithium compound containing one or more of elements B, P, S, Si, Se, and Te.

Preferably, the single-crystal ternary positive electrode material has a specific surface area of 0.3~1 m²/g.

Preferably, the coating layer has a thickness of 5~100 nm.

Preferably, a lithium-nickel cation mixing degree in the single-crystal ternary positive electrode material is < 2%.

In a second aspect, the present application provides a preparation method for the single-crystal ternary positive electrode material as described above, including the following steps:

1) mixing a nickel-cobalt-manganese hydroxide precursor, a lithium source, a M source, and a N source to obtain a primary mixture; subjecting the primary mixture to heating at a rate of 1~5 °C/min to 400~600 °C, and holding for 4~10 hours, then heating at a rate of 1~5 °C/min to 900~1000 °C, and holding for 6~12 hours, then crushing and grading to obtain first particles;

2) mixing the nickel-cobalt-manganese hydroxide precursor, the lithium source, the M source, and the N source to obtain a secondary mixture; subjecting the secondary mixture to heating at a rate of 1~5 °C/min to 400~600 °C, and holding for 4~10 hours, then heating at a rate of 1~5 °C/min to 700~890 °C, and holding for 6~12 hours, then crushing and grading to obtain second particles;

3) mixing the first particles, the second particles, and a coating agent to obtain a tertiary mixture, subjecting the tertiary mixture to heating at a rate of 1~5 °C/min to 250~800 °C, and holding for 5~12 hours to obtain the single-crystal ternary positive electrode material;

where the primary mixture and the secondary mixture are the same or different in composition.

Preferably, the nickel-cobalt-manganese hydroxide precursor has a particle size of 2~5 μm, and has a specific surface area of 5~30 m²/g.

In a third aspect, the present application provides a positive electrode sheet, including the single-crystal ternary positive electrode material as described above.

In a fourth aspect, the present application provides a battery, including the positive electrode sheet as described above.

The single-crystal ternary positive electrode material provided by the present application includes two single-crystal materials with different sizes. In the present application, with the limitation on the particle size and proportion of the single-crystal materials with different sizes, the battery achieves a high electrode compaction density, excellent cycling performance, and a lower battery cell expansion rate.

**BRIEF DESCRIPTION OF DRAWINGS**

Accompanying drawings are incorporated into the specification and form part of this specification, illustrating embodiments of the present application and, together with the specification, serve to explain principles of the present application.

FIG. 1 is an electron microscope image of a single-crystal ternary positive electrode material in Example 1 of the present application.

FIG. 2 is an XRD diagram of the single-crystal ternary positive electrode material in Example 1 of the present application.

FIG. 3 is an electron microscope image of a single-crystal ternary positive electrode material in Example 2 of the present application.

FIG. 4 is an electron microscope image of a single-crystal ternary positive electrode material in Example 3 of the present application.

FIG. 5 is an electron microscope image of a single-crystal ternary positive electrode material in Example 4 of the present application.

FIG. 6 is an electron microscope image of a single-crystal ternary positive electrode material in Comparative Example 1 of the present application.

FIG. 7 is an electron microscope image of a single-crystal ternary positive electrode material in Comparative Example 2 of the present application.

## DESCRIPTION OF EMBODIMENTS

To enable those skilled in the art to better understand the solutions of the present application, the following provides a further detailed description of the present application. The specific embodiments listed below are merely descriptions of the principles and features of the present application, and the examples provided are only for the purpose of explaining the present application and do not limit the scope of the present application. All other embodiments obtained by those skilled in the art based on the embodiments of the present application without making any creative labor are within the scope of protection of the present application.

To improve the compaction density of positive electrode materials containing small-sized single-crystal ternary materials and ensure the cycling performance of the positive electrode materials, the present application involves the following technical solutions.

In a first aspect, the present application provides a single-crystal ternary positive electrode material, satisfying the following equations 1 to 3:

$$1 \ \mu m \leq P < 5 \ \mu m \qquad \text{equation 1,}$$

$$1 \leq D_2/D_1 < 10 \qquad \text{equation 2,}$$

$$3 \ \mu m < D50 < 8 \ \mu m \qquad \text{equation 3;}$$

where P is a single-crystal size of the single-crystal ternary positive electrode material, $D_1$ is a mass proportion of the single-crystal ternary positive electrode material with a single-crystal size < 2.5 $\mu m$, $D_2$ is a mass proportion of the single-crystal ternary positive electrode material with a single-crystal size $\geq$ 2.5 $\mu m$, and D50 is a median particle size of the single-crystal ternary positive electrode material.

It is understood that the single crystal size of the ternary positive electrode material in the present application is within the range of 1-5 $\mu m$, including the single-crystal ternary positive electrode material with a single crystal size < 2.5 $\mu m$ and the ternary positive electrode material with a single crystal size $\geq$ 2.5 $\mu m$.

In the present application, by the control of blending ratio, particle size and other parameters of the large-sized single-crystal ternary material and the small-sized single-crystal ternary material, small-sized single-crystal particles may fill gaps between large-sized single-crystal particles, and the small-sized single-crystal particles provide force-bearing support points for the large-sized single-crystal particles, thereby facilitating an improvement of compaction density of a positive electrode material system; additionally, the positive electrode material system formed by blending the large-sized single-crystal ternary material and the small-sized single-crystal ternary material exhibits excellent stability, ensuring the cycling stability of assembled batteries.

In the present application, a method for measuring a value of P is: obtaining, by using SEM, a surface morphology image of the single-crystal ternary positive electrode material, with the SEM image magnified to 2000 times; and selecting a test point in the image and measuring sizes of single-crystal particles within the test point. The single-crystal particles of the single-crystal ternary positive electrode material are preferably distinct and irregular blocks with smooth and rounded edges. The median particle size D50 represents a particle size at which a cumulative quantity in a particle size cumulative distribution curve is 50% (by volume), and is typically obtained by testing with a laser diffraction particle size distribution analyzer.

In a preferred embodiment, the following equation 4 is further satisfied:

$$1 < N_2/N_1 < 1.2 \qquad \text{equation 4,}$$

where $N_1$ is a Ni content of the single-crystal ternary positive electrode material with a single-crystal size $\geq$ 2.5 $\mu m$, and $N_2$ is a Ni content of the single-crystal ternary positive electrode material with a single-crystal size < 2.5 $\mu m$.

In the present application, it is found that the single-crystal ternary positive electrode material that meets the condition of equation 4 may further improve its specific capacity and other electrical properties.

In a preferred embodiment, the single-crystal ternary positive electrode material includes a core and a coating layer coated on at least part of a surface of the core; the core has a molecular formula of the core is $Li_{1+a}[Ni_xCo_yMn_zM_bN_c]O_2$, where $0 < a < 0.1$, $0 < b < 0.2$, $0 < c < 0.2$, $0.5 \leq x < 1$, $0 < y < 0.3$, $0 < z < 0.3$, $x + y + z + b + c = 1$, M is selected from one or more of Zr, Mg, Ti, Al, La, Ca, Sr, Sb, Nb, Pb, V, Ge, W, Mo, Zn, Ce and Y, and N is selected from one or more of B, P, S, Si, Se and Te; the coating layer includes a metallic lithium compound containing one or more of elements Co, Ti, La, Al, Nb, W, Zr, Y and Ta; and/or a non-metallic lithium compound containing one or more of elements B, P, S, Si, Se and Te; preferably, a lithium compound containing one or more of elements B, P, Co, Ti, Nb and W.

It should be noted that in the present application, a molecular formula of the single-crystal ternary positive electrode material with a single-crystal size $\geq 2.5\ \mu$m may differ from a specific chemical composition of the single-crystal ternary positive electrode material with a single-crystal size $< 2.5\ \mu$m. For example, the single-crystal ternary positive electrode material with a single-crystal size $\geq 2.5\ \mu$m includes a core and a coating layer coated on at least part of a surface of the core, the core has a molecular formula of $Li_{1+a}[Ni_xCo_yMn_zM_bN_c]O_2$; the single-crystal ternary positive electrode material with a single-crystal size $< 2.5\ \mu$m includes a core and a coating layer coated on at least part of a surface of the core, the core has a molecular formula of $Li_{1+a}[Ni_{x'}Co_yMn_zM'_bN'_c]O_2$. Both of the above molecular formulas satisfy $0 < a < 0.1$, $0 < b < 0.2$, $0 < c < 0.2$, $0.5 \leq x < 1$, $0.5 \leq x' < 1$, $1 < x/x' < 1.2$, $0 < y < 0.3$, $0 < z < 0.3$, $x + y + z + b + c = 1$, M and M' are each independently selected from one or more of Zr, Mg, Ti, Al, La, Ca, Sr, Sb, Nb, Pb, V, Ge, W, Mo, Zn, Ce and Y; N and N' are each independently selected from one or more of B, P, S, Si, Se and Te; each of the above two coating layers independently is a metal lithium compound containing one or more of elements Co, Ti, La, Al, Nb, W, Zr, Y and Ta; and/or a non-metal lithium compound containing one or more of elements B, P, S, Si, Se and Te.

In the present application, it is found that a charging cutoff voltage of a battery is related to a content of Ni element in the single-crystal ternary positive electrode material. When x is 0.5~0.6, the charging cutoff voltage of the battery is 4.5~4.6 V; when x is 0.6~0.8, the charging cutoff voltage of the battery is 4.4~4.5 V; when x is 0.8~1 (excluding 0.8), the charging cutoff voltage of the battery is 4.25~4.4 V. In the present application, by controlling the size of the single-crystal ternary material and Ni content of the material with different sizes, a capacity exceeding 200 mAh/g can be achieved at a corresponding charging cutoff voltage, while high cycling performance, rate performance, and a low battery cell expansion rate can be ensured.

Where, a content of Ni element in the single-crystal ternary positive electrode material may be obtained through a testing with an inductively coupled plasma spectrometer (ICP). In some embodiments, the single-crystal ternary positive electrode material is first divided into two parts: one part of the single crystal has a crystal size $< 2.5\ \mu$m and the other part of the single crystal has a crystal size $\geq 2.5\ \mu$m. Finally, contents of Ni element in these two parts of the single-crystal ternary positive electrode material are tested separately using ICP.

Additionally, in the above-mentioned embodiments, by doping M and N elements in a bulk phase and performing surface modification, the single-crystal ternary positive electrode material exhibits superior electrochemical performance, overcoming current shortcomings in capacity and rate performance of single-crystal ternary positive electrode materials, and further enhancing a specific capacity of the single-crystal ternary material.

In some specific embodiments, a content of each of the doping elements M and N is 1~10,000 ppm, preferably 500~3,000 ppm.

In a preferred embodiment, the aforementioned single-crystal ternary positive electrode material is prepared using a method including the following processes:

1) mixing a nickel-cobalt-manganese hydroxide precursor, a lithium source, a M source, and a N source to obtain a primary mixture; subjecting the primary mixture to heating at a rate of 1~5 °C/min to 400~600 °C, and holding for 4~10 hours, then heating at a rate of 1~5 °C/min to 900~1000 °C, and holding for 6~12 hours, then crushing and grading to obtain first particles;

2) mixing the nickel-cobalt-manganese hydroxide precursor, the lithium source, the M source, and the N source to obtain a secondary mixture; subjecting the secondary mixture to heating at a rate of 1~5 °C/min to 400~600 °C, and holding for 4~10 hours, then heating at a rate of 1~5 °C/min to 700~890 °C, and holding for 6~12 hours, then crushing and grading to obtain second particles;

3) mixing the first particles, the second particles, and a coating agent to obtain a tertiary mixture, subjecting the tertiary mixture to heating at a rate of 1~5 °C/min to 250~800 °C, and holding for 5~12 hours to obtain the single-crystal ternary positive electrode material;

where the primary mixture and the secondary mixture are the same or different in composition.

It should be noted that the above steps 1) and 2) have no specific sequence and may be performed simultaneously or sequentially.

For example, the M source is an oxide of one or more of Zr, Mg, Ti, Al, La, Ca, Sr, Sb, Nb, Pb, V, Ge, W, Mo, Zn, Ce and Y; the N source is an oxide of one or more of B, P, S, Si, Se and Te; the lithium source is selected from one or more of lithium hydroxide, lithium carbonate, lithium nitrate, lithium acetate, lithium oxalate, lithium acetate, and lithium oxide; the coating agent is a raw material for the coating layer, selected from one or more of metal oxides containing Co, Ti, La, Al, Nb, W, Zr, Y and Ta; and/or one or more of non-metal oxides containing B, P, S, Si, Se and Te.

In a preferred embodiment, the single-crystal ternary positive electrode material has a specific surface area of 0.3~1 m²/g. Where, the single-crystal ternary positive electrode material with this specific surface area may further ensure the utilization of specific capacity while helping to reduce surface residual alkali.

In a preferred embodiment, the coating layer has a thickness of 5~100 nm; preferably 10~50 nm. Where, in this embodiment, by the control of the thickness of the coating layer, the purpose of further improving the rate performance of the positive electrode material can be achieved.

In a preferred embodiment, a lithium-nickel cation mixing degree in the single-crystal ternary positive electrode material is < 2%. Where, a high Li+/Ni$^{2+}$ mixing degree may lead to an intensification of interfacial side reactions, and lead to more complex change in an electrochemical environment for Ni element during a charging-discharging process. This is an important cause of capacity loss during a first charging-discharging cycle. In contrast, the single-crystal ternary positive electrode material of the present application has a lithium-nickel cation mixing degree of < 2%, which improves the structural stability of the crystal and helps to enhance the cycle stability of the material.

In a second aspect, the present application provides a preparation method for the single-crystal ternary positive electrode material as described above, including following steps:

1) mixing a nickel-cobalt-manganese hydroxide precursor, a lithium source, a M source, and a N source to obtain a primary mixture; subjecting the primary mixture to heating at a rate of 1~5 °C/min to 400~600 °C, and holding for 4~10 hours, then heating at a rate of 1~5 °C/min to 900~1000 °C, and holding for 6~12 hours, then crushing and grading to obtain first particles;

2) mixing the nickel-cobalt-manganese hydroxide precursor, the lithium source, the M source, and the N source to obtain a secondary mixture; subjecting the secondary mixture to heating at a rate of 1~5 °C/min to 400~600°C, and holding for 4~10 hours, then heating at a rate of 1~5 °C/min to 700~890°C, and holding for 6~12 hours, then crushing and grading to obtain second particles;

3) mixing the first particles, the second particles, and a coating agent to obtain a tertiary mixture, subjecting the tertiary mixture to heating at a rate of 1~5 °C/min to 250~800 °C, and holding for 5~12 hours to obtain the single-crystal ternary positive electrode material;

where the primary mixture and the secondary mixture are the same or different in composition.

In the above preparation method, by controlling a sintering process of the primary mixture, the first particles with larger size ($\geq$ 2.5 $\mu$m) may be obtained; then by controlling a sintering process of the secondary mixture, the second particles with smaller size (< 2.5 $\mu$m) may be obtained. Then, depending on the requirements, the first particles, the second particles, and the coating agent are mixed and subjected to coating and sintering to obtain the single-crystal ternary positive electrode material described in any of the first aspect of the present application.

It should be noted that the above steps 1) and 2) have no specific sequence and may be performed simultaneously or sequentially; the purpose of step 3) is merely to coat the surfaces of the first particles and second particles with the coating agent, meaning that the first particles and second particles themselves do not undergo new reactions. Additionally, since the coating agent has a thickness of nanometer level, a required addition amount is extremely small, therefore, its effect on the particle size and mass of the first particles and second particles could be neglected. Consequently, in the present application, a calculation method for the mass proportion ($D_1$) of the single-crystal ternary positive electrode material with a single-crystal size < 2.5 $\mu$m may be: second particles / (first particles + second particles) $\times$ 100%; a calculation method for the mass proportion (D2) of the single-crystal ternary positive electrode material with a single-crystal size $\geq$ 2.5 $\mu$m may be: first particles / (first particles + second particles) $\times$ 100%; or, a calculation method for D1 and D2 may be grading the resulting single-crystal ternary positive electrode material, then calculating the mass proportion ($D_1$) of the single-crystal ternary positive electrode material with a single-crystal size < 2.5 $\mu$m and the mass proportion ($D_2$) of the single-crystal ternary positive electrode material with a single-crystal size $\geq$ 2.5 $\mu$m, separately. Regardless of the calculation method, the single-crystal ternary positive electrode material provided in the present application meets the condition of the above equation 2.

In the present application, when the primary mixture and secondary mixture are the same in composition, a main difference between the second particles and second particles obtained is their sizes. However, when the primary mixture and secondary mixture are different in composition, for example, the M source and N source have different addition amounts and/or types, the second particles and second particles obtained not only have different sizes but also have different bulk doping elements. At this time, this is more conducive to leveraging the synergistic effect of different doping elements, enabling the single-crystal ternary positive electrode material to have more excellent electrochemical performance.

Preferably, when the coating agent contains one or more of the elements Co, Ti, La, Al, Nb, W, Zr, Y, and Ta, a tertiary mixture is subjected to heating at a rate of 1~5 °C/min to 500~800 °C, and holding for 5~10 hours to obtain third particles. When the coating agent further contains one or more of the elements B, P, S, Si, Se, and Te, the third particles are subjected to heating at a rate of 1~5 °C/min to 250~500 °C, holding for 5~10 hours, and then screening to obtain the single-crystal ternary positive electrode material.

More preferably, when the coating agent contains only one or more of the elements B, P, S, Si, Se, and Te, the third particles are directly subjected to heating at a rate of 1~5 °C/min to 250~500 °C, holding for 5~10 hours, and screening to obtain the single-crystal ternary positive electrode material.

Exemplarily, the M source is an oxide of one or more of Zr, Mg, Ti, Al, La, Ca, Sr, Sb, Nb, Pb, V, Ge, W, Mo, Zn, Ce and Y; the N source is an oxide of one or more of B, P, S, Si, Se and Te; the lithium source is selected from one or more of lithium hydroxide, lithium carbonate, lithium nitrate, lithium acetate, lithium oxalate, lithium acetate, and lithium oxide; the coating agent is a raw material for a coating layer, selected from one or more of metal oxides containing Co, Ti, La, Al, Nb, W, Zr, Y, and Ta; and/or one or more of non-metal oxides containing B, P, S, Si, Se, and Te.

When the single-crystal ternary positive electrode material prepared according to the present application satisfies the equation 4, i.e., the first particles and second particles with different nickel contents are needed to be synthesized in the steps 1) and 2), we generally achieve this by controlling the molecular formula of the nickel-cobalt-manganese hydroxide precursor, i.e., the nickel-cobalt-manganese hydroxide precursors in steps 1) and 2) have different molecular formulas. For example, in step 1), the molecular formula of the nickel-cobalt-manganese hydroxide precursor is $Ni_xCo_yMn_z(OH)_2$, where $0.5 \leq x < 1$, $0 < y < 0.3$, $0 < z < 0.3$, and $x + y + z = 1$; in Step 2), the molecular formula of the nickel-cobalt-manganese hydroxide precursor is $Ni_{x'}Co_{y'}Mn_{z'}(OH)_2$, where $0.5 \leq x' < 1$, $0 < y' < 0.3$, $0 < z' < 0.3$, and $x' + y' + z' = 1$; and $1 < x'/x < 1.2$.

In the present application, the nickel-cobalt-manganese hydroxide precursor may be purchased directly or prepared using a conventional method, for example, mixing a soluble nickel salt and a manganese salt to form a mixed salt solution, introducing a protective gas into a reactor, adding the mixed salt solution, an alkali solution, a complexing agent to perform a coprecipitation reaction, adjusting pH of the mixed solution after reacting for 3~5 hours until the particle size of the product reaches a desired particle size, stopping the reaction to complete the reaction, then subjecting the resulting mixed solution to aging, filtering, washing, and drying to obtain the desired nickel-cobalt-manganese hydroxide precursor; where each of the nickel salt and manganese salt is a corresponding sulfate, nitrate, chloride, etc.

In the present application, the mixing in step 1) or step 2) is preferably uniformly mixed in a high-speed mixer; in step 1) or step 2), the crushing and grading preferably are operations specifically including jaw crushing, roller crushing, mechanical crushing, and screening. The purpose of these operations is to separate the synthesized agglomerated solid product into the primary particles and to remove, by screening, a small amount of solid particles that do not meet the size requirements of the present application.

In some embodiments, the jaw crushing may be implemented using a jaw crusher, and the mechanical crushing may be implemented using an airflow crusher.

In a more preferred embodiment, the primary mixture is subjected to heating at a rate of 3~5 °C/min to 450~550 °C, holding for 4~6 hours, then heating at a rate of 3~5 °C/min to 900~1000 °C, holding for 6~8 hours, and crushing and grading to obtain the first particles; the first particles have an average particle size of 3~4 $\mu$m; the secondary mixture is subjected to heating at a rate of 3~5 °C/min to 450~550 °C, holding for 4~6 hours, then heating at a rate of 3~5 °C/min to 750~850 °C, holding for 6~8 hours, and crushing and grading to obtain the second particles; the first particles have an average particle size of 1~2 $\mu$m.

In a preferable embodiment, the nickel-cobalt-manganese hydroxide precursor has a particle size of 2~5 $\mu$m, and has a specific surface area of 5~30 $m^2/g$.

Where, the particle size of the aforementioned nickel-cobalt-manganese hydroxide precursor refers to D50 of the nickel-cobalt-manganese hydroxide precursor, which represents a particle size at which a cumulative quantity in the particle size cumulative distribution curve is 50% (by volume), and can be obtained by testing with a laser diffraction particle size distribution analyzer.

In some embodiments, the particle size of the nickel-cobalt-manganese hydroxide precursor is any one of the values 2 $\mu$m, 2.5 $\mu$m, 3 $\mu$m, 3.5 $\mu$m, 4 $\mu$m, 4.5 $\mu$m, and 5 $\mu$m, or any range formed by any two of the above values. The specific surface area is 5 $m^2/g$, 6 $m^2/g$, 7 $m^2/g$, 8 $m^2/g$, 9 $m^2/g$, 10 $m^2/g$, 11 $m^2/g$, 15 $m^2/g$, 16 $m^2/g$, 17 $m^2/g$, 18 $m^2/g$, 19 $m^2/g$, 20 $m^2/g$, 21 $m^2/g$, 22 $m^2/g$, 23 $m^2/g$, 24 $m^2/g$, 25 $m^2/g$, 26 $m^2/g$, 27 $m^2/g$, 28 $m^2/g$, 29 $m^2/g$, 30 $m^2/g$, or any range formed by any two of the above values.

In the present application, it is found that the selection of the nickel-cobalt-manganese hydroxide precursor with specific parameters facilitates the preparation of the blended single-crystal ternary positive electrode material of specific sizes, thereby increasing the ratio of the single-crystal ternary positive electrode material that meets the size requirements of the equations 1-3 of the present application.

In a third aspect, the present application provides a positive electrode sheet including the aforementioned single-crystal ternary positive electrode material.

It should be understood that the positive electrode sheet includes a current collector and a positive electrode slurry coated on the current collector. Exemplarily, the positive electrode slurry includes: the aforementioned single-crystal ternary positive electrode material, a conductive agent, a binder, and a solvent. The binder may include any one of or a combination of at least two of polyvinylidene fluoride, polyvinylpyrrolidone, carboxymethyl cellulose sodium, and styrene-butadiene rubber. The solvent may include any one of or a combination of at least two of deionized water, N-methylpyrrolidone, N,N-dimethylformamide, N,N-dimethylacetamide, and anhydrous ethanol. The conductive agent may include any one of or a combination of at least two of conductive graphite, carbon nanotube conductive carbon black, acetylene black, Kotchen black, vapor-grown carbon fiber, and expanded graphite.

In a fourth aspect, the present application provides a battery including the above-mentioned positive electrode sheet.

The following specific embodiments are provided to further illustrate the present application:

Example 1

A single-crystal ternary positive electrode material is provided, and its preparation method is as follows:

(1) preparation of large-sized single-crystal ternary semi-finished product A: weighing lithium hydroxide, $Ni_{0.83}Co_{0.06}Mn_{0.11}(OH)_2$, $ZrO_2$, and $MoO_3$ (D50 = 3.5 $\mu$m, specific surface area is approximately 15 m$^2$/g), with a molar ratio of Li / (Ni + Co + Mn) = 1.05, Zr addition of 1500 ppm, and Mo addition of 1000 ppm , mixing uniformly in a high-speed mixer, loading the mixed material into a crucible, sintering in a high-temperature atmosphere box furnace under an oxygen atmosphere, heating at a rate of 3 °C/min to 500 °C, holding for 4 hours, then heating to 950 °C and holding for 6 hours, subjecting the sintered material to jaw crushing, roller crushing, grinding, and screening to obtain the large-sized single-crystal ternary semi-finished product $Li_{1.03}Ni_{0.83}Co_{0.0574}Mn_{0.11}Mo_{0.001}Zr_{0.0016}O_2$, with a single-crystal size $\geq$ 2.5 $\mu$m and an average value of 3.0 $\mu$m.

(2) preparation of small-sized single-crystal ternary semi-finished product a: weighting lithium hydroxide, $Ni_{0.85}Co_{0.05}Mn_{0.10}(OH)_2$ (D50 = 3.5 $\mu$m, specific surface area is approximately 15 m$^2$/g) $Al_2O_3$, and $MoO_3$, with a molar ratio of Li / (Ni + Co + Mn) = 1.04, Al addition of 1000 ppm, and Mo addition of 1000 ppm, mixing uniformly in the high-speed mixer, loading the mixed material into the crucible, sintering in the high-temperature atmosphere box furnace under an oxygen atmosphere, heating at a rate of 3 °C/min to 500 °C, holding for 4 hours, then heating to 850 °C and holding for 6 hours, subjecting the sintered material to jaw crushing, roller crushing, crushing by an airflow crusher, and screening to obtain the small-sized single-crystal ternary semi-finished product $Li_{1.03}Ni_{0.85}Co_{0.0454}Mn_{0.10}Mo_{0.001}Al_{0.0036}O_2$, with a single-crystal size < 2.5 $\mu$m and an average value of 1.2 $\mu$m.

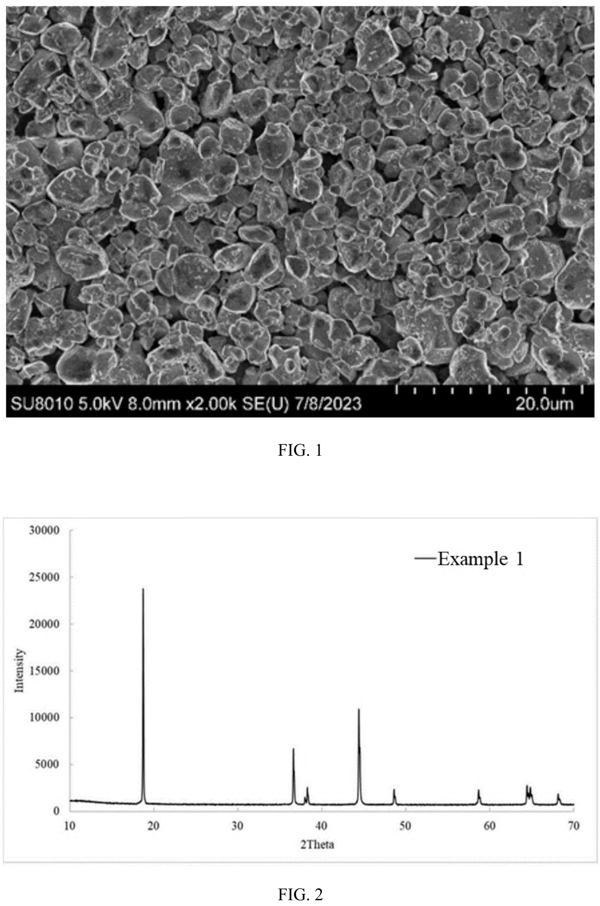

(3) preparation of finished product single-crystal ternary positive electrode material: mixing the two types of single-crystal ternary semi-finished particles A and a in a weight ratio of 9:1, weighing nano-additives $Al_2O_3$ and $TiO_2$ with Al element of 1500 ppm and Ti element of 1000 ppm, mixing them uniformly with the two types of single-crystal ternary semi-finished materials A and a, loading the mixed material into the crucible and sintering in the high-temperature atmosphere box furnace under an oxygen atmosphere, heating at a rate of 3 °C/min to 650 °C and holding for 6 hours, subjecting the material to cooling, then powdering and sieving to obtain the single-crystal ternary positive electrode material with two different particle sizes blended together. Parameters, such as single-crystal size of the single-crystal ternary positive electrode material, ratio of the mass proportion of the single-crystal ternary positive electrode material with a single-crystal size $\geq$ 2.5 $\mu$m to the mass proportion of the single-crystal ternary positive electrode material with a single-crystal size < 2.5 $\mu$m, and median particle size of the single-crystal ternary positive electrode material, are shown in Table 1. The XRD test results are shown in FIG. 2. According to XRD refinement analysis, lithium-nickel cation mixing degree is 1.90%.

Example 2

A single-crystal ternary positive electrode material is provided, whose preparation method differs from Example 1 in that: in step (3), the two types of single-crystal ternary semi-finished particles, A and a, are mixed in a weight ratio of 8:2. According to XRD refinement analysis, the lithium-nickel cation mixing degree is 1.85%. Parameters, such as single-crystal size of the single-crystal ternary positive electrode material, ratio of the mass proportion of the single-crystal ternary positive electrode material with a single-crystal size $\geq$ 2.5 $\mu$m to the mass proportion of the single-crystal ternary positive electrode material with a single-crystal size < 2.5 $\mu$m, and median particle size of the single-crystal ternary positive electrode material, are shown in Table 1.

Example 3

A single-crystal ternary positive electrode material is provided, whose preparation method differs from Example 1 in that: in step (3), the two types of single-crystal ternary semi-finished particles, A and a, are mixed in a weight ratio of 7:3. According to XRD refinement analysis, lithium-nickel cation mixing degree is 1.86%. Parameters, such as single-crystal size of the single-crystal ternary positive electrode material, ratio of the mass proportion of the single-crystal ternary positive electrode material with a single-crystal size $\geq$ 2.5 $\mu$m to the mass proportion of the single-crystal ternary positive electrode material with a single-crystal size < 2.5 $\mu$m, and median particle size of the single-crystal ternary positive electrode material, are shown in Table 1.

Example 4

A single-crystal ternary positive electrode material is provided, whose preparation method differs from Example 1 in that: in step (3), the two types of single-crystal ternary semi-finished particles, A and a, are mixed in a weight ratio of 6:4. According to XRD refinement analysis, lithium-nickel cation mixing degree is 1.80%. Parameters, such as single-crystal size of the single-crystal ternary positive electrode material, ratio of the mass proportion of the single-crystal ternary positive electrode material with a single-crystal size $\geq 2.5$ $\mu$m to the mass proportion of the single-crystal ternary positive electrode material with a single-crystal size < 2.5 $\mu$m, and median particle size of the single-crystal ternary positive electrode material, are shown in Table 1.

Example 5

A single-crystal ternary positive electrode material is provided, whose preparation method differs from Example 1 in that: in step (3), the two types of single-crystal ternary semi-finished particles, A and a, are mixed in a weight ratio of 5:5. According to XRD refinement analysis, lithium-nickel cation mixing degree is 1.75%. Parameters, such as single-crystal size of the single-crystal ternary positive electrode material, ratio of the mass proportion of the single-crystal ternary positive electrode material with a single-crystal size $\geq 2.5$ $\mu$m to the mass proportion of the single-crystal ternary positive electrode material with a single-crystal size < 2.5 $\mu$m, and median particle size of the single-crystal ternary positive electrode material, are shown in Table 1.

Example 6

A single-crystal ternary positive electrode material (with structural parameters as shown in Table 1) is provided, whose preparation method differs from Example 2 in that: in step (2), the precursor is $Ni_{0.88}Co_{0.05}Mn_{0.07}(OH)_2$, and the XRD analysis indicates that the lithium-nickel cation mixing degree is 1.95%. Parameters, such as single-crystal size of the single-crystal ternary positive electrode material, ratio of the mass proportion of the single-crystal ternary positive electrode material with a single-crystal size $\geq 2.5$ $\mu$m to the mass proportion of the single-crystal ternary positive electrode material with a single-crystal size < 2.5 $\mu$m, and median particle size of the single-crystal ternary positive electrode material, are shown in Table 1.

Example 7

A single-crystal ternary positive electrode material is provided, and its preparation method is as follows:

(1) preparation of large-sized single-crystal ternary semi-finished product A as described in Example 1.
(2) preparation of small-sized single-crystal ternary semi-finished product a as described in Example 1.
(3) preparation of the finished single-crystal ternary positive electrode material: mixing the two types of single-crystal ternary semi-finished particles, A and a, in a weight ratio of 8:2, weighing nano-additives $Al_2O_3$ and $CeO_2$ with Al element of 1500 ppm and Ce element of 1000 ppm, mixing them uniformly with the two types of single-crystal ternary semi-finished materials A and a, loading the mixed material into a crucible and sintering in a high-temperature atmosphere box furnace, under an oxygen atmosphere heating at a rate of 3 °C/min to 650 °C and holding for 6 hours, subjecting the material to cooling, then powdering and sieving to obtain the single-crystal ternary positive electrode material with two different particle sizes blended together. According to XRD refinement analysis, the lithium-nickel cation mixing degree is 1.82%. Parameters, such as single-crystal size of the single-crystal ternary positive electrode material, ratio of the mass proportion of the single-crystal ternary positive electrode material with a single-crystal size $\geq$ 2.5 $\mu$m to the mass proportion of the single-crystal ternary positive electrode material with a single-crystal size < 2.5 $\mu$m, and median particle size of the single-crystal ternary positive electrode material, are shown in Table 1.

Example 8

A single-crystal ternary positive electrode material is provided, and its preparation method is as follows:

(1) preparation of large-sized single-crystal ternary semi-finished product A as described in Example 1.
(2) preparation of small-sized single-crystal ternary semi-finished product a as described in Example 1.
(3) preparation of the finished single-crystal ternary positive electrode material: mixing the two types of single-crystal ternary semi-finished particles, A and a, in a weight ratio of 8:2, weighing nano-additives $Al_2O_3$, $Nb_2O_5$ and $WO_3$ with Al element of 1500 ppm, Nb element of 1000 ppm and W element of 800 ppm, mixing them uniformly with the two types of single-crystal ternary semi-finished materials A and a, loading the mixed material into a crucible and sintering in a high-temperature atmosphere box furnace, under an oxygen atmosphere heating at a rate of 3 °C/min to 600 °C and holding for 6 hours, subjecting the material to cooling, then powdering and sieving to obtain the single-crystal ternary positive electrode materials with two different particle sizes blended together. According to XRD refinement analysis, the lithium-nickel cation mixing degree is 1.73%. Parameters, such as single-crystal size of the single-crystal ternary positive electrode material, ratio of the mass proportion of the single-crystal ternary positive electrode material with a single-crystal size $\geq$ 2.5 $\mu$m to the mass proportion of the single-crystal ternary positive electrode material with a single-crystal size < 2.5 $\mu$m, and median particle size of the single-crystal ternary positive electrode material, are shown in Table 1.

Example 9

A single-crystal ternary positive electrode material is provided, and its preparation method is as follows:

(1) preparation of large-sized single-crystal ternary semi-finished product A as described in Example 1.
(2) preparation of small-sized single-crystal ternary semi-finished product a as described in Example 1.
(3) preparation of the finished single-crystal ternary positive electrode material: mixing the two types of single-crystal ternary semi-finished particles, A and a, in a weight ratio of 8:2, weighing nano-additive $H_3BO_3$ with B element of 1500 ppm, mixing them uniformly with the two types of single-crystal ternary semi-finished materials A and a, loading the mixed material into a crucible and sintering in a high-temperature atmosphere box furnace, under an oxygen atmosphere heating at a rate of 3 °C/min to 300 °C and holding for 10 hours, subjecting the material to cooling, then powdering and sieving to obtain the single-crystal ternary positive electrode materials with two different particle sizes blended together. According to XRD refinement analysis, the lithium-nickel cation mixing degree is 1.74%. Parameters, such as single-crystal size of the single-crystal ternary positive electrode material, ratio of the mass proportion of the single-crystal ternary positive electrode material with a single-crystal size $\geq$ 2.5 $\mu$m to the mass proportion of the single-crystal ternary positive electrode material with a single-crystal size < 2.5 $\mu$m, and median particle size of the single-crystal ternary positive electrode material, are shown in Table 1.

Comparative Example 1

A single-crystal ternary positive electrode material is provided, and its preparation method is as follows:

(1) weighing lithium hydroxide, $Ni_{0.85}Co_{0.05}Mn_{0.1}(OH)_2$ (D50 = 3.5 $\mu$m, specific surface area is approximately 15 $m^2$/g), $ZrO_2$, and $MoO_3$, with a molar ratio of Li / (Ni + Co + Mn) = 1.05, Zr addition of 1500 ppm, and Mo addition of 1000 ppm, mixing uniformly in a high-speed mixer, loading the mixed material into a crucible, sintering in a high-temperature atmosphere box furnace under an oxygen atmosphere, heating at a rate of 3 °C/min to 500 °C, holding for 4 hours, then heating to 950 °C and holding for 6 hours, subjecting the sintered material to jaw crushing, roller crushing, grinding, and screening to obtain a large-sized single-crystal ternary semi-finished product, with a single-crystal size $\geq$ 2.5 $\mu$m and an average value of 3.0 $\mu$m.
(2) then weighing nano-additives $Al_2O_3$ and $TiO_2$, with Al element of 1500 ppm and Ti element of 1000 ppm, mixing them uniformly with the single-crystal ternary semi-finished material, loading the mixed material into the crucible and sintering in the high-temperature atmosphere box furnace, under an oxygen atmosphere, heating at a rate of 3 °C/min to 650 °C and holding for 6 hours, subjecting the material to cooling, then powdering and sieving to obtain a large-sized single-crystal ternary positive electrode material (with structural parameter as shown in Table 1). According to XRD refinement analysis, the lithium-nickel cation mixing degree is 1.93%.

Comparative Example 2

A single-crystal ternary positive electrode material is provided, and its preparation method is as follows:

(1) weighing lithium hydroxide, $Ni_{0.88}Co_{0.05}Mn_{0.07}(OH)_2$ (D50 = 3.5 $\mu$m, specific surface area is approximately 15 $m^2$/g), $Al_2O_3$, and $MoO_3$, with a molar ratio of Li / (Ni + Co + Mn) = 1.04, Al addition of 1000 ppm, and Mo addition of 1000 ppm, mixing uniformly in a high-speed mixer, loading the mixed material into a crucible and sintering in a high-temperature atmosphere box furnace, under an oxygen atmosphere heating at a rate of 3 °C/min to 500 °C, holding for 4 hours, then heating to 850 °C and holding for 6 hours, subjecting the sintered material to jaw crushing, roller crushing, grinding, and screening to obtain a large-sized single-crystal ternary semi-finished product, with a single-crystal size < 2.5 $\mu$m and an average value of 1.2 $\mu$m.
(2) then weighing nano-additives $Al_2O_3$ and $TiO_2$, with Al element of 1500 ppm and Ti element of 1000 ppm, mixing them uniformly with the single-crystal ternary semi-finished material, loading the mixed material into the crucible and sintering in the high-temperature atmosphere box furnace, under an oxygen atmosphere heating at a rate of 3 °C/min to 650 °C and holding for 6 hours, subjecting the material to cooling, then powdering and sieving to obtain a small-sized single-crystal ternary positive electrode material (with structural parameter as shown in Table 1). According to XRD refinement analysis, the lithium-nickel cation mixing degree is 1.89%.

Comparative Example 3

A single-crystal ternary positive electrode material (with structural parameters as shown in Table 1) is provided, whose preparation method is the same as Example 1, with the difference being that in step (3), the two types of single-crystal ternary semi-finished particles A and a are mixed in a weight ratio of 4:6.

Comparative Example 4

The preparation method is the same as in Example 1, with the difference being that the precursor in step (1) is $Ni_{0.85}Co_{0.05}Mn_{0.10}(OH)_2$ (D50 = 3.5 $\mu$m, specific surface area is approximately 15 $m^2/g$), and the precursor in step (2) is $Ni_{0.83}Co_{0.06}Mn_{0.11}(OH)_2$ (D50 = 3.5 $\mu$m, specific surface area is approximately 15 $m^2/g$).

Comparative Example 5

A single-crystal ternary positive electrode material (with structural parameters as shown in Table 1) is provided, whose preparation method is the same as that in Example 1, with the only difference being that in step (1), heating at a rate of 3 °C/min to 500 °C, holding for 4 hours, then heating to 1000 °C and holding for 6 hours are performed.

Testing methods:

Initial capacity: at a temperature of 25°C and under normal pressure (0.1 MPa), the single-crystal ternary positive electrode material from each example and comparative example, conductive carbon black, and a binder polyvinylidene fluoride (PVDF) are uniformity mixed in a mass percentage ratio of 95:3:2 in a solvent N-methylpyrrolidone through fully stirring to obtain a positive electrode slurry. The positive electrode slurry is coated onto an aluminum foil, then dried and cold-pressed to obtain a positive electrode sheet having a positive electrode active layer having a thickness of 100 $\mu$m. The positive electrode sheet, a lithium sheet, a separator, and an electrolyte solution are assembled into a button cell in a inert atmosphere glove box. The button cell is charged at a constant current of 0.2C until the voltage reaches a cutoff voltage, then under the cutoff voltage it is charged at a constant voltage until the current is less than 0.05C, the charge capacity at this moment is recorded as a first-cycle charge capacity. After standing for 5 minutes, it is discharged at a constant current of 0.2C until the voltage reaches 2.5V, the discharge capacity at this moment is recorded as a first-cycle discharge specific capacity, which is also an initial capacity.

Rate performance: a button cell is prepared according to the method described in the initial capacity test. The button cell is charged at a constant current of 0.1C until the voltage reaches a cutoff voltage, then under the cutoff voltage it is charged at a constant voltage until the current is less than 0.05C. After standing for 5 minutes, it is discharged at a constant current of 0.1C until the voltage reaches 2.5V, the capacity at this moment is recorded as a discharge capacity at 0.1C. After standing for 10 minutes, it is charged at a constant current of 1C until the voltage reaches the cutoff voltage, then under the cutoff voltage it is charged at a constant voltage until the current is less than 0.05C. After standing for 5 minutes, it is discharged at a constant current of 1C until the voltage reaches 2.5V, the capacity at this moment is recorded as a discharge capacity at 1C. The discharge capacity at 1C divided by the discharge capacity at 0.1C is the rate performance at 1C.

Full-electric cycle: a full battery is formed by a positive electrode sheet formed by coating the positive electrode material according to the method described in the initial capacity test, a negative electrode (graphite), a separator (polyethylene), and an electrolyte solution (the electrolyte solution is LiPF6, with a solvent of EC/DMC). Under 1C charge-discharge condition, cycling is performed, a capacity retention rate is determined by comparing a capacity of each cycle to that of a first cycle. At 45 °C, the capacity retention rate is calculated after 300 cycles.

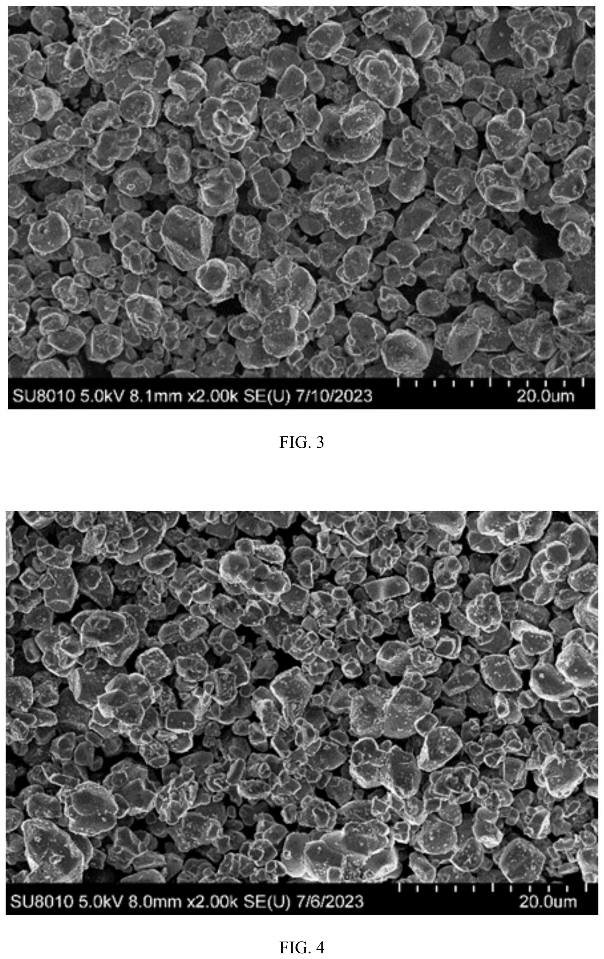

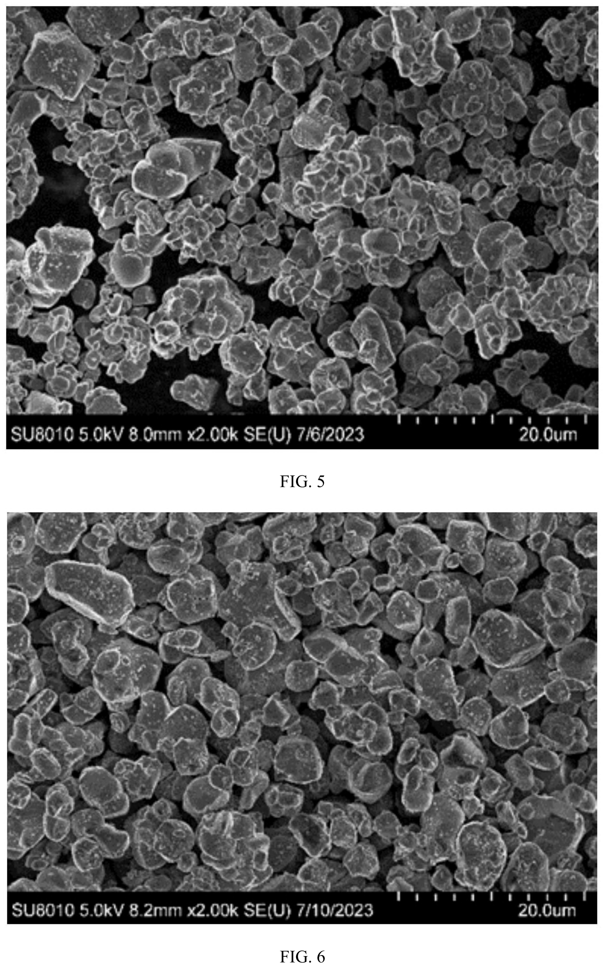

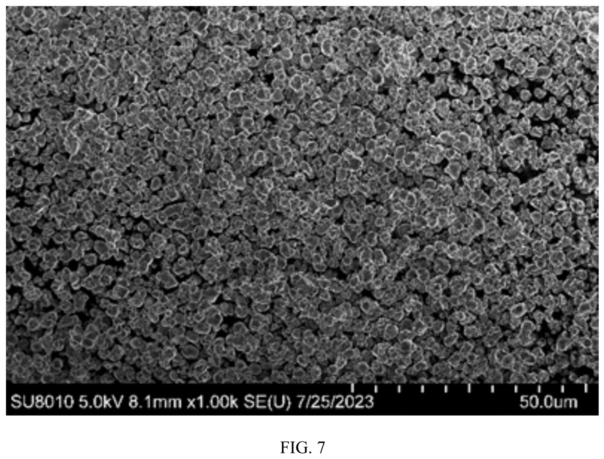

Single crystal size measurement: a surface morphology image of each positive electrode material is obtained using SEM (as shown in FIGS. 1, 2-7), with the SEM image of the positive electrode material magnified to 2000 times. Test points are selected in the SEM image, sizes of 300 crystal particles having a size ≥2.5 $\mu$m are measured respectively, then an average size is calculated to determine the size of the large-sized crystal particles. Similarly, sizes of 300 crystal particles having a size < 2.5 $\mu$m are measured respectively, then an average size is calculated to determine the size of the small-sized crystal particles.

BET measurement: approximately 5 g of each of single-crystal ternary positive electrode material samples from examples and comparative examples is weighed, placed in a long tube having a spherical bubble, subjected to vacuum treatment at 200 °C for 2 hours at first, then subjected to gas adsorption by introducing $N_2$. An adsorption amount of the test sample for adsorbate molecules ($N_2$) is determined based on the change in pressure or weight before and after the adsorption to obtain a BET specific surface area.

Battery cell expansion: a full battery is assembled according to the method used in the full-electric cycle test. The battery is fully charged to a set voltage of 4.3 V, a thickness of the battery is measured using a PPG battery thickness gauge; the battery is placed in a constant-temperature oven at 70 °C for 28 days and then taken out, the thickness of the battery is measured again using the PPG battery thickness gauge. A battery thickness expansion rate is calculated using the following formula: battery thickness expansion rate = (battery thickness after constant-temperature treatment - battery thickness before constant-temperature treatment) / battery before constant-temperature treatment.

Electrode sheet compaction: areal density of electrode sheet / (thickness of electrode sheet after rolling -thickness of current collector).

The test results of the above tests are summarized in Table 1:

Table 1

| Groups | Ni$_2$:Ni$_1$ | Single-crystal size ($\mu$m) and mass proportion | D$_2$/D$_1$ | BET m$^2$/g | Median **particle** size ($\mu$m) | Electrode sheet compaction (g/cm$^3$) | Initial capacity mAh/g | Rate perform ance 1C/0.1C | Cycling perform ance /1C/300 cycles | Battery cell expansi on /% |
|---|---|---|---|---|---|---|---|---|---|---|
| Example 1 | 1.02 | 3.0(90%)+1. 2(10%) | 9 | 0.42 | 5.10 | 3.6 | 203.45 | 92.40% | 93.6% | 17.4 |
| Example 2 | 1.02 | 3.0(80%)+1. 2(20%) | 4 | 0.43 | 4.86 | 3.6 | 203.78 | 92.56% | 94.0% | 16.6 |
| Example 3 | 1.02 | 3.0(70%)+1. 2(30%) | 3.5 | 0.45 | 4.69 | 3.6 | 204.10 | 92.70% | 93.8% | 17.2 |
| Example 4 | 1.02 | 3.0(60%)+1. 2(40%) | 1.5 | 0.48 | 4.52 | 3.6 | 204.45 | 92.86% | 93.4% | 17.5 |
| Example 5 | 1.02 | 3.0(50%)+1. 2(50%) | 1 | 0.50 | 4.35 | 3.6 | 204.78 | 93.20% | 93.2% | 17.6 |
| Example 6 | 1.02 | 3.0(80%)+1. 2(20%) | 4 | 0.43 | 5.21 | 3.6 | 204.34 | 92.60% | 93.8% | 17.8 |
| Example 7 | 1.02 | 3.0(80%)+1. 2(20%) | 4 | 0.43 | 5.23 | 3.6 | 203.85 | 92.54% | 93.7% | 16.8 |
| Example 8 | 1.02 | 3.0(80%)+1. 2(20%) | 4 | 0.43 | 5.22 | 3.6 | 203.89 | 92.64% | 93.9% | 16.6 |
| Example 9 | 1.02 | 3.0(80%)+1. 2(20%) | 4 | 0.43 | 5.19 | 3.6 | 204.25 | 92.56% | 93.7% | 17.2 |
| Comparativ e Example 1 | 0 | 3.0(100%) | / | 0.3 | 5.20 | 3.55 | 202 | 90.5% | 91.2% | 18 |
| Comparativ e Example 2 | / | 1.2(100%) | / | 0.9 | 3.5 | 3.45 | 206.4 | 93.8% | 88.8% | 25 |
| Comparativ e Example 3 | 1.02 | 3.0(40%)+1. 2(60%) | 0.67 | 0.6 | 4.25 | 3.6 | 204.85 | 92.24% | 92.5% | 20 |
| Comparativ e Example 4 | 0.97 | 3.0(80%)+1. 2(20%) | 4 | 0.43 | 4.86 | 3.6 | 205 | 91.5% | 87.3% | 30 |
| Comparativ e Example 5 | 1.02 | 5.0(80%)+1. 2(20%) | 4 | 0.29 | 8.0 | 3.7 | 200 | 90.2% | 88.6% | 25 |

Note: N$_1$ represents a Ni content in a single-crystal ternary positive electrode material having a single crystal size ≥2.5 $\mu$m, and N$_2$ represents a Ni content in the single-crystal ternary positive electrode material having a single crystal size < 2.5 $\mu$m.

As shown in Table 1, compared to the comparative examples, the batteries, which are assembled using the single-crystal ternary positive electrode materials in Examples 1-9 by controlling the parameters such as blending ratio and particle size of large-sized and small-sized single-crystal ternary materials, exhibit higher initial capacity, rate performance and cycling performance, and lower battery cell expansion rate. Specifically, in Comparative Example 1, since all sizes of single crystals of the single-crystal ternary positive electrode material are great than or equal to 2.5 $\mu$m, gaps between single-crystal particles are large, this affects diffusion of lithium ions in the solid phase, resulting in poor rate performance and cycling performance, and higher battery cell expansion rate of the assembled battery. In Comparative Example 2, since all sizes of single crystals of the single crystal ternary positive electrode material are less than 2.5 $\mu$m, their specific surface areas are large and have strong reactivity, this leads to an increase of side reactions, resulting in poorer cycling performance and higher battery cell expansion rate. In Comparative Example 3, the mass proportion of the single-crystal ternary positive electrode material having a single-crystal size $\geq$2.5 $\mu$m is smaller than that of the single-crystal ternary positive electrode material having a single-crystal size <2.5 $\mu$m, resulting in slightly reduced overall stability of the assembled battery and a higher battery cell expansion rate compared to the examples. In Comparative Example 4, the Ni content of the single-crystal ternary positive electrode material having a single-crystal size $\geq$ 2.5 $\mu$m is relatively high, the battery's initial capacity is higher, while its stability is decreased. In Comparative Example 5, the median particle size of the single-crystal ternary positive electrode material is too large, and the particles have relatively poor adsorption property; an increased length of the diffusion path for lithium ions in the solid phase slows their migration rate during charging and discharging processes, resulting in poorer rate performance and cycling performance, and higher battery cell expansion rate of the assembled battery.

By comparing FIGS. 1 and 3-7, it can be seen that the single-crystal ternary positive electrode materials in Examples 1-4 each include a certain proportion of large-sized particles and small-sized particles, with an overall size ranging from 1 to 5 $\mu$m, while the single-crystal ternary positive electrode materials in Comparative Examples 1-2 each are composed of either large-sized single-crystal particles or small-sized single-crystal particles.

Finally, it should be noted that the above embodiments are provided merely for describing the technical solutions of the present application other than limiting the present application. Although the present application has been described in detail with reference to the aforementioned embodiments, those skilled in the art should understand that they may still make modifications to the technical solutions described in the aforementioned embodiments, or make equivalent substitutions to some or all of the technical features. Such modifications or substitutions do not cause the corresponding technical solutions to depart from the scope of the technical solutions of embodiments of the present application.

## Claims

1. A single-crystal ternary positive electrode material, wherein the single-crystal ternary positive electrode material satisfies the following equations 1 to 3:

$$1 \ \mu m \leq P < 5 \ \mu m \qquad \text{equation 1,}$$

$$1 \leq D_2/D_1 < 10 \qquad \text{equation 2,}$$

$$3 \ \mu m < D50 < 8 \ \mu m \qquad \text{equation 3;}$$

wherein P is a single-crystal size of the single-crystal ternary positive electrode material, $D_1$ is a mass proportion of the single-crystal ternary positive electrode material with a single-crystal size < 2.5 $\mu$m, $D_2$ is a mass proportion of the single-crystal ternary positive electrode material with a single-crystal size $\geq$ 2.5 $\mu$m, and D50 is a median particle size of the single-crystal ternary positive electrode material.

2. The single-crystal ternary positive electrode material according to claim 1, wherein the single-crystal ternary positive electrode material further satisfies the following equation 4:

$$1 < N_2/N_1 < 1.2 \qquad \text{equation 4,}$$

wherein $N_1$ is a Ni content of the single-crystal ternary positive electrode material with a single-crystal size $\geq$ 2.5 $\mu$m, and $N_2$ is a Ni content of the single-crystal ternary positive electrode material with a single-crystal size < 2.5 $\mu$m.

3. The single-crystal ternary positive electrode material according to claim 1 or 2, wherein the single-crystal ternary positive electrode material comprises a core and a coating layer coated on at least part of a surface of the core; the core has a molecular formula of $Li_{1+a}[Ni_xCo_yMn_zM_bNc]O_2$, where $0 < a < 0.1$, $0 < b < 0.2$, $0 < c < 0.2$, $0.5 \leq x < 1$, $0 < y < 0.3$, $0 < z < 0.3$, $x + y + z + b + c = 1$, M is selected from one or more of Zr, Mg, Ti, Al, La, Ca, Sr, Sb, Nb, Pb, V, Ge, W, Mo, Zn, Ce and Y, and N is selected from one or more of B, P, S, Si, Se and Te; the coating layer comprises a metallic lithium compound containing one or more of elements Co, Ti, La, Al, Nb, W, Zr, Y, and Ta; and/or a non-metallic lithium compound containing one or more of elements B, P, S, Si, Se, and Te.

4. The single-crystal ternary positive electrode material according to any one of claims 1 to 3, wherein the single-crystal ternary positive electrode material has a specific surface area of $0.3\sim1$ $m^2/g$.

5. The single-crystal ternary positive electrode material according to claim 3, wherein the coating layer has a thickness of $5\sim100$ nm.

6. The single-crystal ternary positive electrode material according to any one of claims 1 to 5, wherein a lithium-nickel cation mixing degree in the single-crystal ternary positive electrode material is <2%.

7. A preparation method for the single-crystal ternary positive electrode material according to any one of claims 1 to 6, comprising the following steps:

   1) mixing a nickel-cobalt-manganese hydroxide precursor, a lithium source, a M source, and a N source to obtain a primary mixture; subjecting the primary mixture to heating at a rate of $1\sim5°C$/min to $400\sim600°C$, and holding for $4\sim10$ hours, then heating at a rate of $1\sim5°C$/min to $900\sim1000°C$, and holding for $6\sim12$ hours, then crushing and grading to obtain first particles;
   2) mixing the nickel-cobalt-manganese hydroxide precursor, the lithium source, the M source, and the N source to obtain a secondary mixture; subjecting the secondary mixture to heating at a rate of $1\sim5°C$/min to $400\sim600°C$, and holding for $4\sim10$ hours, then heating at a rate of $1\sim5°C$/min to $700\sim890°C$, and holding for $6\sim12$ hours, then crushing and grading to obtain second particles;
   3) mixing the first particles, the second particles, and a coating agent to obtain a tertiary mixture, subjecting the tertiary mixture to heating at a rate of $1\sim5°C$/min to $250\sim800°C$, and holding for $5\sim12$ hours to obtain the single-crystal ternary positive electrode material;

   wherein the primary mixture and the secondary mixture are the same or different in composition.

8. The preparation method according to claim 7, wherein the nickel-cobalt-manganese hydroxide precursor has a particle size of $2\sim5$ $\mu m$, and has a specific surface area of $5\sim30 m^2/g$.

9. A positive electrode sheet, comprising the single-crystal ternary positive electrode material according to any one of claims 1 to 6.

10. A battery, comprising the positive electrode sheet according to claim 9.

FIG. 1

FIG. 2

FIG. 3

FIG. 4

FIG. 5

FIG. 6

FIG. 7

## INTERNATIONAL SEARCH REPORT

| International application No. |
| --- |
| **PCT/CN2024/134001** |

| A. | CLASSIFICATION OF SUBJECT MATTER |
| --- | --- |

C30B29/10(2006.01)i; H01M4/505(2010.01)i; H01M4/525(2010.01)i

According to International Patent Classification (IPC) or to both national classification and IPC

| B. | FIELDS SEARCHED |
| --- | --- |

Minimum documentation searched (classification system followed by classification symbols)

IPC: C30B, H01M

Documentation searched other than minimum documentation to the extent that such documents are included in the fields searched

Electronic data base consulted during the international search (name of data base and, where practicable, search terms used)

CNABS, CNTXT, CNKI, VEN, DWPI, ENTXT, ISI Web of Science: 三元, 单晶, 正极, 电池, 锂, 钴, 镍, 锰, 粒径, 尺寸, 不同, 配比, 比例, 混合, 密度, 循环, 容百, ternary, Lithium, Nickel, Cobalt, Manganese, electrode, battery, single crystal+, unit crystal+, mono crystal+, monocrystal+, size?, diameter?, different, mix+, ratio, density, cycle

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| PX | CN 117604637 A (NINGBO RONBAY NEW ENERGY TECHNOLOGY CO., LTD.) 27 February 2024 (2024-02-27) <br> claims 1-10 | 1-10 |
| A | CN 117071072 A (WANHUA CHEMICAL (YANTAI) BATTERY MATERIAL TECHNOLOGY CO., LTD. et al.) 17 November 2023 (2023-11-17) <br> claims 1-10 | 1-10 |
| A | CN 104724763 A (JIANGSU KING LITHIUM CELL CO., LTD.) 24 June 2015 (2015-06-24) <br> entire document | 1-10 |
| A | CN 109516509 A (CNGR ADVANCED MATERIAL CO., LTD.) 26 March 2019 (2019-03-26) <br> entire document | 1-10 |
| A | CN 107978751 A (NINGBO RONBAY LITHIUM BATTERY MATERIAL CO., LTD.) 01 May 2018 (2018-05-01) <br> entire document | 1-10 |

| ✓ Further documents are listed in the continuation of Box C. | ✓ See patent family annex. |
| --- | --- |

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
| --- | --- |
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **19 February 2025** | **25 February 2025** |

| Name and mailing address of the ISA/CN | Authorized officer |
| --- | --- |
| **China National Intellectual Property Administration (ISA/CN)** <br> **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
|---|
| **PCT/CN2024/134001** |

## C. DOCUMENTS CONSIDERED TO BE RELEVANT

| Category* | Citation of document, with indication, where appropriate, of the relevant passages | Relevant to claim No. |
|---|---|---|
| A | CN 114703544 A (BEIJING EASPRING MATERIAL TECHNOLOGY CO., LTD.) 05 July 2022 (2022-07-05)<br>entire document | 1-10 |
| A | CN 114927659 A (BEIJING EASPRING MATERIAL TECHNOLOGY CO., LTD.) 19 August 2022 (2022-08-19)<br>entire document | 1-10 |

Form PCT/ISA/210 (second sheet) (July 2022)

**INTERNATIONAL SEARCH REPORT**
Information on patent family members

International application No.

**PCT/CN2024/134001**

| Patent document cited in search report | | | Publication date (day/month/year) | Patent family member(s) | | | Publication date (day/month/year) |
|---|---|---|---|---|---|---|---|
| CN | 117604637 | A | 27 February 2024 | None | | | |
| CN | 117071072 | A | 17 November 2023 | None | | | |
| CN | 104724763 | A | 24 June 2015 | None | | | |
| CN | 109516509 | A | 26 March 2019 | CN | 109516509 | B | 10 August 2021 |
| CN | 107978751 | A | 01 May 2018 | CN | 107978751 | B | 03 July 2020 |
| CN | 114703544 | A | 05 July 2022 | CN | 114703544 | B | 14 July 2023 |
| | | | | WO | 2022207008 | A1 | 06 October 2022 |
| | | | | EP | 4159897 | A1 | 05 April 2023 |
| | | | | US | 2023202866 | A1 | 29 June 2023 |
| | | | | KR | 20230098502 | A | 04 July 2023 |
| | | | | JP | 2023540162 | W | 22 September 2023 |
| | | | | EP | 4159897 | A4 | 13 December 2023 |
| | | | | JP | 7398015 | B2 | 13 December 2023 |
| | | | | KR | 102669854 | B1 | 27 May 2024 |
| | | | | US | 12157679 | B2 | 03 December 2024 |
| CN | 114927659 | A | 19 August 2022 | CN | 114927659 | B | 28 May 2024 |

Form PCT/ISA/210 (patent family annex) (July 2022)

**EP 4 722 426 A1**

**Patent documents cited in the description**

- CN 202311586595